# FASCICULE DE BREVET EUROPEEN

(11) **EP 4 550 968 B1**
(45) Date de publication et mention de la délivrance du brevet: **11.02.2026**
(21) Numéro de dépôt: 24210499.0
(22) Date de dépôt: 04.11.2024
(51) Int. Cl.: H10B 63/00, H10B 63/10, H10N 70/20, H10N 70/00

(54) **DISPOSITIF MÉMOIRE COMPRENANT DES CELLULES MÉMOIRE RRAM À SURFACE ACTIVE OPTIMISÉE**
SPEICHERVORRICHTUNG MIT RRAM-SPEICHERZELLEN MIT OPTIMIERTER AKTIVER OBERFLÄCHE
MEMORY DEVICE INCLUDING RRAM MEMORY CELLS WITH OPTIMIZED ACTIVE AREA

(30) Priorité: 06.11.2023 FR 2312005
(43) Date de publication de la demande: 07.05.2025
(73) Titulaire: Commissariat à l'Energie Atomique et aux Energies Alternatives, 75015 Paris (FR)
(72) Inventeur: PARES, Gabriel, 38054 Grenoble Cedex 9 (FR)
(74) Mandataire: Cabinet Beaumont

(56) Documents cités:
- US-A1- 2012 091 419
- US-A1- 2012 176 834
- US-A1- 2018 012 937
- US-A1- 2022 293 679

## Description

### Domaine technique

La présente description concerne de façon générale le domaine des mémoires non volatiles de type résistives (RRAM ou ReRAM) à base d'oxyde (OxRAM) ou d'électrolyte métallique (CBRAM) .

### Technique antérieure

Le bloc principal d'une mémoire est formé d'une matrice de cellules mémoire, ou « bitcells » en anglais. Chaque cellule mémoire comporte au moins un transistor de sélection et au moins un point mémoire réalisant la mémorisation de l'information pour la cellule mémoire. Les cellules mémoire sont couplées électriquement à des éléments de connexion électrique formés par des niveaux métalliques, ou niveau de métallisation, superposés correspondant au BEOL (« Back End Of Line » en anglais) du circuit.

Dans une mémoire de type OxRAM, chaque point mémoire est généralement formé par une structure verticale en mesa, ou en îlot, dans laquelle une portion d'oxyde est disposée entre des électrodes supérieure et inférieure sous la forme d'un empilement vertical. Le document P. Polakowski et al., "Ferroelectric deep trench capacitors based on Al:HfO2 for 3D nonvolatile memory applications", 2014 IEEE 6th International Memory Workshop (IMW), Taipei, Taiwan, 2014, pp. 1-4, décrit une telle configuration.

D'autres architectures de point mémoire ont été envisagées, par exemple sous la forme d'une structure 3D cylindrique telle que décrite dans le document G. Piccolboni et al., "Investigation of the potentialities of Vertical Resistive RAM (VRRAM) for neuromorphic applications," 2015 IEEE International Electron Devices Meeting (IEDM), Washington, DC, USA, 2015, pp. 17.2.1-17.2.4. Un autre exemple se trouve dans le document US2022293679.

Dans un point mémoire de type OxRAM, la surface active, qui correspond à la surface de contact entre la portion d'oxyde et les électrodes, détermine une grande partie des caractéristiques électriques du point mémoire. Pour les différentes architectures verticales de point mémoire précédemment mentionnées, cette surface active est toutefois limitée par la surface totale disponible pour la cellule dans le plan de la matrice de cellules mémoire. Une réduction de la surface totale disponible pour la cellule mémoire s'accompagne alors d'une réduction de la surface active du point mémoire, ce qui engendre plusieurs problèmes : augmentation de la tension permettant la mémorisation de l'information dans le point mémoire, augmentation de la variabilité des paramètres électriques (courant, tension) des points mémoire, perte de rendement.

Des problèmes similaires se retrouvent également pour les mémoires de type CBRAM.

### Résumé de l'invention

Il existe donc un besoin de proposer une structure mémoire résistive permettant une réduction de la surface d'occupation des cellules mémoire tout en limitant ou supprimant les problèmes précédemment mentionnés.

Un mode de réalisation propose une solution à tout ou partie des inconvénients des solutions connues et propose un dispositif mémoire comprenant, dans un premier niveau de métallisation :
- des premières lignes d'interconnexion électrique parallèles les unes aux autres,
- des portions métalliques parallèles les unes aux autres et couplant électriquement chacune deux premières lignes d'interconnexion électrique voisines,
et dans lequel un point mémoire de type OxRAM ou CBRAM est disposé à chaque interface entre une des portions métalliques et une des premières lignes d'interconnexion électrique, et chaque point mémoire comprend une première électrode disposée contre ladite une des premières lignes d'interconnexion électrique, une deuxième électrode disposée contre ladite une des portions métalliques, et une couche mémoire disposée entre les première et deuxième électrodes.

Selon un mode de réalisation particulier, les premières lignes d'interconnexion électrique, les portions métalliques et les points mémoires sont disposés, ou réalisés, dans un même plan longitudinal parallèle à un substrat du dispositif mémoire.

Selon un mode de réalisation particulier, chaque point mémoire comporte en outre une portion de matériau getter disposée entre la couche mémoire et l'une des première et deuxième électrodes.

Selon un mode de réalisation particulier, le dispositif mémoire comprend en outre, dans un deuxième niveau de métallisation parallèle au premier niveau de métallisation, des deuxièmes lignes d'interconnexion électrique parallèles les unes aux autres et couplées électriquement aux portions métalliques ou aux premières lignes d'interconnexion électrique.

Selon un mode de réalisation particulier, le dispositif mémoire comprend en outre des premiers vias électriquement conducteurs couplant électriquement les deuxièmes lignes d'interconnexion électrique aux portions métalliques ou aux premières lignes d'interconnexion électrique.

Selon un mode de réalisation particulier, lorsque les deuxièmes lignes d'interconnexion électrique sont couplées électriquement aux portions métalliques, les premières lignes d'interconnexion électrique sont des lignes de source du dispositif mémoire et les deuxièmes lignes d'interconnexion électrique sont des lignes de bits du dispositif mémoire.

Selon un mode de réalisation particulier, le premier niveau de métallisation est disposé entre le deuxième niveau de métallisation et le substrat du dispositif mémoire.

Selon un mode de réalisation particulier, le substrat comporte une couche de semi-conducteur dans laquelle sont formés des transistors dont l'une des électrodes de source ou de drain de chacun des transistors est couplée électriquement à l'une des premières lignes d'interconnexion électrique ou à l'une des portions métalliques par un deuxième via électriquement conducteur s'étendant entre la couche de semi-conducteur et ladite une des premières lignes d'interconnexion électrique ou entre la couche de semi-conducteur et ladite une des portions métalliques.

Selon un mode de réalisation particulier, le dispositif comprend, dans un troisième niveau de métallisation parallèle aux premier et deuxième niveaux de métallisation et tel que le premier niveau de métallisation soit disposé entre les deuxième et troisième niveaux de métallisation, des troisièmes lignes d'interconnexion électrique parallèles les unes aux autres et perpendiculaires aux premières lignes d'interconnexion électrique, et les troisièmes lignes d'interconnexion électrique sont couplées électriquement aux grilles des transistors.

Selon un mode de réalisation particulier, chacune des deux premières lignes d'interconnexion électrique voisines est couplée électriquement à des points mémoire qui sont couplés électriquement à des deuxièmes lignes d'interconnexion électrique différentes.

Selon un mode de réalisation particulier, les premières lignes d'interconnexion électrique s'étendent dans un plan perpendiculaire à des faces de plus grandes dimensions de la couche mémoire et des première et deuxième électrodes.

Selon un mode de réalisation particulier, il est proposé un procédé de réalisation d'un dispositif mémoire, comprenant au moins :
- réalisation, dans un premier niveau de métallisation, de premières lignes d'interconnexion électrique parallèles les unes aux autres, et de portions métalliques parallèles les unes aux autres et couplant électriquement chacune deux premières lignes d'interconnexion électrique voisines,
- réalisation, à chaque interface entre une des portions métalliques et une des premières lignes d'interconnexion électrique, d'un point mémoire de type OxRAM ou CBRAM comprenant une première électrode disposée contre ladite une des premières lignes d'interconnexion électrique, une deuxième électrode disposée contre ladite une des portions métalliques, et une couche mémoire disposée entre les première et deuxième électrodes.

Selon un mode de réalisation particulier, les premières lignes d'interconnexion électrique, les portions métalliques et les points mémoire sont réalisés en mettant en œuvre les étapes suivantes :
- gravure, dans une première couche diélectrique, de premières tranchées définissant des emplacements pour les premières lignes d'interconnexion électrique,
- dépôt d'au moins un premier matériau métallique dans les premières tranchées, formant les premières électrodes des points mémoire, et d'au moins un deuxième matériau métallique formant les premières lignes d'interconnexion électrique,
- gravure, dans la première couche diélectrique, de premiers trous définissant des emplacements pour les portions métalliques et les points mémoire,
- dépôts successifs de plusieurs matériaux dans les premiers trous, formant les points mémoire et les portions métalliques.

Selon un mode de réalisation particulier, le procédé comporte en outre, après la réalisation des premières lignes d'interconnexion électrique, des portions métalliques et des points mémoire :
- dépôt d'au moins une deuxième couche diélectrique sur les premières lignes d'interconnexion électrique, les portions métalliques et les points mémoire,
- gravure, à travers une première partie de l'épaisseur de la deuxième couche diélectrique, de deuxièmes tranchées parallèles les unes aux autres et définissant des emplacements pour des deuxièmes lignes d'interconnexion électrique,
- gravure, à travers une deuxième partie de l'épaisseur de la deuxième couche diélectrique, sous les deuxièmes tranchées et à l'aplomb des portions métalliques ou des premières lignes d'interconnexion électrique, de deuxièmes trous définissant des emplacements pour des premiers vias électriquement conducteur,
- dépôt d'au moins un autre matériau métallique dans les deuxièmes trous et dans les deuxièmes tranchées, formant les deuxièmes lignes d'interconnexion électrique et les premiers vias électriquement conducteur couplant électriquement l'une des deuxièmes lignes d'interconnexion électrique aux portions métalliques ou aux premières lignes d'interconnexion électrique.

Selon un mode de réalisation particulier, le procédé comporte en outre, préalablement à la réalisation des premières lignes d'interconnexion électrique, des portions métalliques et des points mémoire, la réalisation, à partir d'une couche de semi-conducteur d'un substrat, de transistors dont l'une des électrodes de source ou de drain de chacun des transistors est couplée électriquement à l'une des premières lignes d'interconnexion électrique ou à l'une des portions métalliques par un deuxième via électriquement conducteur s'étendant entre la couche de semi-conducteur et ladite une des premières lignes d'interconnexion électrique ou entre la couche de semi-conducteur et ladite une des portions métalliques.

Selon un mode de réalisation particulier, la réalisation des transistors inclut la réalisation de grilles couplées électriquement à des troisièmes lignes d'interconnexion électrique parallèles les unes aux autres et perpendiculaires aux premières lignes d'interconnexion électrique.

### Brève description des dessins

Ces caractéristiques et avantages, ainsi que d'autres, seront exposés en détail dans la description suivante d'exemples de réalisation particuliers faite à titre non limitatif en relation avec les figures jointes parmi lesquelles :
la figure 1 représente schématiquement une partie d'un exemple de dispositif mémoire ;
la figure 2 représente schématiquement une cellule mémoire d'un dispositif mémoire selon un mode de réalisation particulier ;
la figure 3 représente schématiquement les points mémoire d'une cellule mémoire du dispositif mémoire selon un mode de réalisation particulier ;
la figure 4 représente un schéma électrique de plusieurs cellules mémoire du dispositif mémoire selon un mode de réalisation particulier ;
la figure 5 représente schématiquement une vue de dessus de l'agencement de deux cellules mémoire du dispositif mémoire selon un mode de réalisation particulier ;
la figure 6 représente schématiquement une partie d'une matrice de cellules mémoire d'un dispositif mémoire selon un mode de réalisation particulier ;
la figure 7 représente des caractéristiques géométriques des points mémoire d'un dispositif mémoire ;
la figure 8, la figure 9, la figure 10, la figure 11, la figure 12 et la figure 13 représentent une partie des étapes d'un procédé de réalisation d'un dispositif mémoire.

### Description des modes de réalisation

De mêmes éléments ont été désignés par de mêmes références dans les différentes figures. En particulier, les éléments structurels et/ou fonctionnels communs aux différents exemples de réalisation peuvent présenter les mêmes références et peuvent disposer de propriétés structurelles, dimensionnelles et matérielles identiques.

Par souci de clarté, seuls les étapes et éléments utiles à la compréhension des exemples de réalisation décrits ont été représentés et sont détaillés. En particulier, différents éléments (circuit de lecture, décodeur de ligne, décodeur de colonne, etc.) du dispositif mémoire ne sont pas détaillés. Une réalisation détaillée de ces éléments est dans la capacité de l'homme du métier en utilisant la description fonctionnelle donnée ci-dessous.

Sur les différentes figures, les éléments visibles ne sont pas représentés à la même échelle les uns par rapport aux autres pour faciliter la compréhension de ces figures.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, dans une position normale d'utilisation du dispositif.

Sauf précision contraire, les expressions "environ", "approximativement", "sensiblement", et "de l'ordre de" signifient à 10 % près, de préférence à 5 % près.

Dans toute ce document, les termes « premier », « deuxième » et « troisième » utilisés pour désigner et distinguer les différents niveaux de métallisation du dispositif ne présument pas de leur ordre de réalisation et de leur disposition par rapport au substrat du dispositif. Ainsi, le « premier niveau de métallisation » ne correspond pas nécessairement au niveau de métallisation M1 du circuit. De même, les « deuxième niveau de métallisation » et « troisième niveau de métallisation » ne correspondent pas nécessairement aux niveaux de métallisation M2 et M3 du circuit.

La description ci-dessous de mémoires résistives à base d'oxyde (OxRAM) peut s'appliquer de la même manière aux mémoires résistives de type CBRAM, en remplaçant les éléments constitutifs de ces mémoires OxRAM par leur équivalent des mémoires CBRAM, à savoir notamment les électrodes inférieure et supérieure par respectivement une électrode chimiquement inerte et une électrode chimiquement active, et la couche résistive par un électrolyte solide.

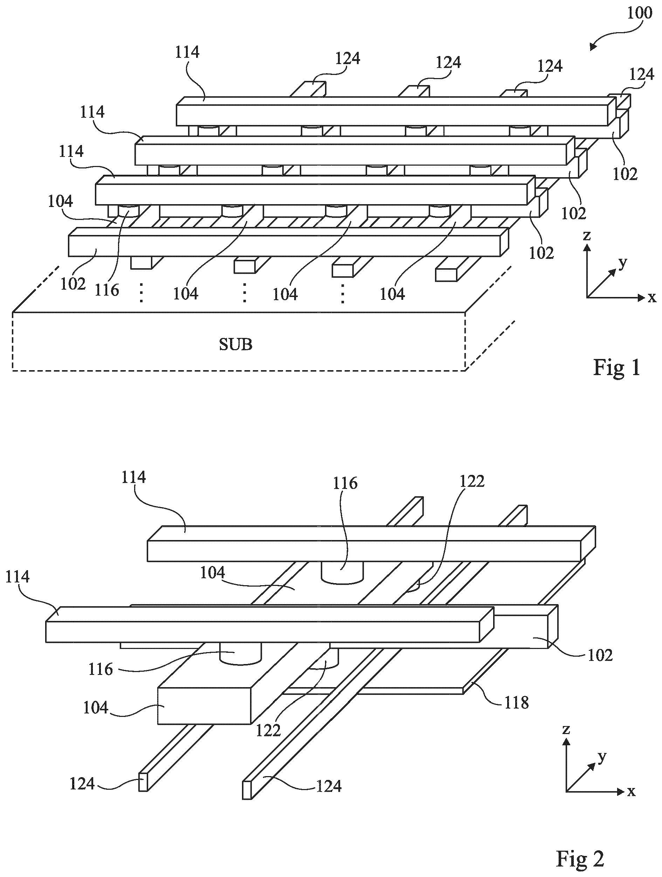

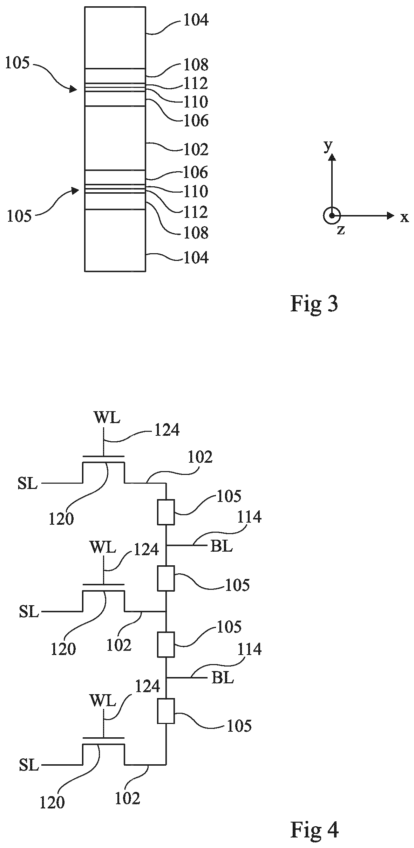

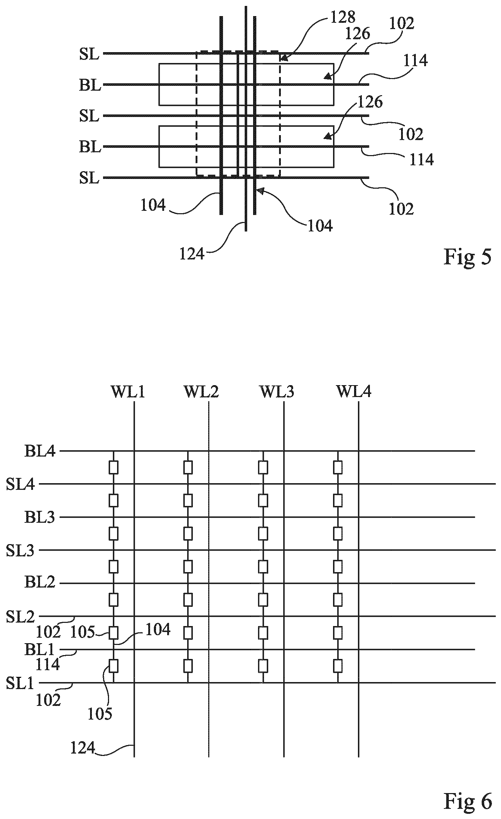

Un exemple de dispositif mémoire 100 selon un mode de réalisation particulier est décrit ci-dessous en lien avec les figures 1 à 5. La figure 1 représente schématiquement une partie du dispositif 100. La figure 2 représente schématiquement une cellule mémoire du dispositif 100. La figure 3 représente schématiquement les points mémoire d'une cellule mémoire du dispositif 100. La figure 4 représente un schéma électrique de plusieurs cellules mémoire du dispositif 100. La figure 5 représente schématiquement une vue de dessus de l'agencement (ou « layout » en anglais) de deux cellules mémoire du dispositif 100.

Le dispositif mémoire 100 comporte une matrice de cellules mémoire s'étendant dans un plan parallèle au plan (X,Y) visible sur la figure 1. Le dispositif 100 est par exemple réalisé sous la forme d'un circuit intégré comprenant un substrat SUB sur et/ou dans lequel des composants, dont les transistors des cellules mémoire, sont réalisés. Le circuit comporte également plusieurs niveaux de métallisation, ou niveaux métalliques (« Metal Layer » en anglais), réalisés au-dessus du substrat SUB, formant le BEOL du circuit et dans lequel les points mémoire des cellules mémoire sont réalisés.

Le dispositif 100 comporte, dans un premier niveau de métallisation correspondant par exemple au niveau de métallisation M4 du circuit, des premières lignes d'interconnexion électrique 102 parallèles les unes aux autres (parallèles à l'axe X visible sur la figure 1). Selon un exemple de réalisation, les premières lignes 102 comportent au moins l'un des matériaux métalliques suivants : tungstène, cuivre, cobalt. En outre, les premières lignes 102 sont réalisées dans une couche diélectrique non visible sur la figure 1 et comprenant par exemple du SiO₂. L'épaisseur (dimension parallèle à l'axe Z) des premières lignes 102 est par exemple comprise entre 50 nm et 500 nm. Chacune des premières lignes 102 peut être commune à l'ensemble des cellules mémoire disposées sur une même ligne de la matrice de cellules mémoire.

Le dispositif 100 comporte également, dans le premier niveau de métallisation, des portions métalliques 104 parallèles les unes des autres et couplant électriquement chacune deux premières lignes 102 voisines. Sur l'exemple de la figure 1, chacune des portions métalliques 104 s'étend entre deux premières lignes 102 voisines parallèlement à l'axe Y. Selon un exemple de réalisation, les portions métalliques 104 comportent au moins l'un des matériaux métalliques suivants : cuivre, tungstène, cobalt. Les portions métalliques 104 sont réalisées dans la même couche diélectrique que celle dans laquelle les premières lignes 102 sont réalisées. L'épaisseur des portions métalliques 104 est ici similaire à celle des premières lignes 102.

Dans le dispositif 100, un point mémoire 105 de type OxRAM est disposé à chaque interface d'une des portions métalliques 104 et d'une des premières lignes 102. Deux exemples de ces points mémoire 105 sont visibles sur la figure 3.

Chacun des points mémoire 105 comporte une première électrode 106 disposée contre l'une des premières lignes 102, et une deuxième électrode 108 disposée contre l'une des portions métalliques 104. Selon un exemple de réalisation, les première et deuxième électrodes 106, 108 comportent par exemple du TiN, qui a pour avantage d'être un matériau stable chimiquement apportant une neutralité électro-chimique aux électrodes 106, 108. En variante, les première et deuxième électrodes 106, 108 peuvent comporter du TaN ou du WN.

Chacun des points mémoire 105 comporte également une couche mémoire 110 disposée entre les première et deuxième électrodes 106, 108, et dans laquelle la mémorisation de l'information du point mémoire 105 est destinée à être réalisée. Dans le cas d'un point mémoire 105 de type OxRAM, la couche mémoire 110 correspond à une couche résistive, par exemple une portion d'oxyde. Selon un exemple de réalisation, la portion d'oxyde 110 comporte du HfO₂.

Dans l'exemple de réalisation particulier décrit, chaque point mémoire 105 comporte en outre une portion de matériau getter 112 disposée entre la couche mémoire 110 et l'une des première et deuxième électrodes 106, 108. Sur l'exemple de la figure 3, pour chaque point mémoire 105, la portion 112 est disposée entre la couche mémoire 110 et la deuxième électrode 108 (c'est-à-dire l'électrode disposée contre la portion métallique 104 du point mémoire 105). La portion 112 contribue, dans cet exemple, à la création d'un ou plusieurs filaments électriquement conducteurs dans la couche mémoire 110 lors du fonctionnement du dispositif 100. Selon un exemple de réalisation, la portion 112 comporte du titane, ou du tantale, ou de l'hafnium, ou tout autre matériau ayant une affinité électro-chimique avec l'oxygène.

La dimension selon l'axe Z de la couche 110 et de la portion 112 est par exemple similaire à l'épaisseur des premières lignes 102.

Dans l'exemple décrit ci-dessus, chaque point mémoire 105 est formé par l'empilement des électrodes 106, 108, de la couche 110 et de la portion 112, cet empilement étant agencé « horizontalement », c'est-à-dire en s'étendant entre l'une des premières lignes 102 et l'une des portions 104 selon une direction appartenant au plan dans lequel se trouvent les premières lignes 102 et les portions 104. Dans l'exemple décrit, la direction de l'empilement (parallèle à l'axe Y sur les figures 1 à 3) formant chaque point mémoire 105 est perpendiculaire à la direction selon laquelle les premières lignes 102 s'étendent.

Dans l'exemple décrit, les premières lignes d'interconnexion électrique 102, les portions métalliques (104) et les points mémoires 105 sont disposées dans un même plan longitudinal parallèle au substrat SUB du dispositif mémoire 100.

Dans le mode de réalisation particulier décrit, les premières lignes 102 s'étendent dans un plan perpendiculaire à des faces de plus grandes dimensions de la couche mémoire 110 et des première et deuxième électrodes 106, 108.

En outre, dans chaque point mémoire 105, la surface active est définie par la dimension selon l'axe X de la portion métallique 104 et l'épaisseur de la première ligne 102 et de la portion métallique 104. Ainsi, une réduction de la surface totale de la cellule mémoire dans le plan de la matrice de cellules mémoire n'impacte pas directement la surface active de chaque point mémoire 105 et peut être compensée par une augmentation de l'épaisseur des lignes 102 et des portions 104.

Dans l'exemple de réalisation décrit, le dispositif 100 comporte également, dans un deuxième niveau de métallisation, parallèle au premier niveau de métallisation, du dispositif 100 et correspondant par exemple au niveau de métallisation M5 du circuit, des deuxièmes lignes d'interconnexion électrique 114 parallèles les unes aux autres. Dans l'exemple de réalisation décrit ici, les deuxièmes lignes d'interconnexion électrique 114 sont également parallèles aux premières lignes 102.

Dans le mode de réalisation particulier décrit, le dispositif 100 peut comporter également des vias électriquement conducteurs 116 s'étendant entre les premier et deuxième niveaux de métallisation du dispositif 100 et chacun couplant électriquement l'une des deuxièmes lignes 114 à l'une des portions métalliques 104. Dans un autre exemple de réalisation, les deuxièmes lignes 114 peuvent être directement couplées électriquement aux portions métalliques 104 sans vias intermédiaires. Dans une autre configuration non représentée sur les figures, les deuxièmes lignes 114 peuvent être disposées perpendiculairement aux premières lignes 102 et couplées électriquement aux portions métalliques 104 par les vias 116. Les deuxièmes lignes 114 et/ou les vias 116 comportent un ou plusieurs matériaux métalliques par exemple similaire(s) à celui ou ceux des portions métalliques 104. Les deuxièmes lignes 114 et les vias 116 peuvent être disposées dans au moins une couche diélectrique non visible sur les figures 1 à 5 et comprenant par exemple du SiO₂.

Les deuxièmes lignes 114 et les vias 116 couplent électriquement entre elles les portions 104 disposées sur une même ligne de la matrice de cellules mémoire, c'est-à-dire disposées entre les mêmes deux premières lignes 102. Au sein des cellules mémoire du dispositif 100, l'accès électrique aux premières électrodes 106 des points mémoire 105 peut donc être réalisé via les premières lignes 102 et l'accès électrique aux deuxièmes électrodes 108 peut être réalisé via les deuxièmes lignes 114, les vias 116 et les portions métalliques 104.

Le dispositif 100 comporte en outre un substrat SUB comprenant une couche de semi-conducteur 118 dans laquelle sont formés des transistors 120. L'agencement du substrat est tel que le premier niveau de métallisation est disposé entre le deuxième niveau de métallisation et le substrat.

Dans l'exemple de réalisation décrit, les transistors 120 correspondent à des transistors de sélection des cellules mémoire. L'une des électrodes de source ou de drain (suivant la conductivité des transistors) de chacun des transistors 120 est couplée électriquement à l'une des premières lignes 102 par un via électriquement conducteur 122 s'étendant entre la couche de semi-conducteur 118 et cette première ligne 102. L'autre électrode de source ou de drain est couplée électriquement à un circuit de commande du dispositif 100.

Le dispositif 100 comprend, dans un troisième niveau de métallisation tel que le premier niveau de métallisation soit disposé entre les deuxième et troisième niveaux de métallisation (le troisième niveau de métallisation étant parallèle aux premier et deuxième niveaux de métallisation), et correspondant par exemple au niveau de métallisation M3 du circuit, des troisièmes lignes d'interconnexion électrique 124 parallèles les unes aux autres et perpendiculaires au moins aux premières lignes 102 et éventuellement aux deuxièmes lignes 114 suivant leur orientation. Sur l'exemple représenté sur les figures 1 et 2, les troisièmes lignes 124 sont parallèles à l'axe Y. Les troisièmes lignes 124 sont couplées électriquement aux grilles des transistors 120 et permettent de sélectionner par exemple une colonne de transistors.

Selon un exemple de réalisation, les troisièmes lignes 124 comportent au moins l'un des matériaux métalliques suivants : cuivre, nitrure de titane, nitrure de tantale. En outre, les troisièmes lignes 124 et les vias 122 sont réalisés dans une couche diélectrique non visible sur les figures 1 à 5 et comprenant par exemple du SiO₂. L'épaisseur (dimension parallèle à l'axe Z) des troisièmes lignes 124 est par exemple comprise entre 40 nm et 500 nm suivant le nœud technologique CMOS utilisé. Chacune des troisièmes lignes 124 peut être commune à l'ensemble des transistors disposés sur une même colonne de la matrice de cellules mémoire.

Selon un exemple de réalisation, les premières lignes 102 peuvent correspondre à des lignes de source (« source line » en anglais) du dispositif 100 et les deuxièmes lignes 114 peuvent correspondre à des lignes de bits (« bit line » en anglais) du dispositif 100. De plus, il est possible que les troisièmes lignes 124 forment des lignes de mot (« word line » en anglais) du dispositif 100.

Le schéma électrique de plusieurs cellules mémoire du dispositif 100 est visible sur la figure 4. Dans ce mode de réalisation, chacune des deux premières lignes 102 voisines (entre lesquelles s'étendent les portions métalliques 102) est couplée électriquement à des points mémoire 105 qui sont couplés électriquement à des deuxièmes lignes 114 différentes.

Chaque cellule mémoire du dispositif 100 comporte donc, dans ce mode de réalisation, deux points mémoire 105 couplés à une même ligne de bit, c'est-à-dire une même deuxième ligne 114. De plus, chaque ligne de source, c'est-à-dire chaque première ligne 102, est partagée par deux cellules mémoire voisines.

La figure 5 représente schématiquement une vue de dessus (vue dans le plan (X, Y)) de l'agencement de deux cellules mémoire du dispositif 100. Sur cette figure, les régions désignées par la référence 126 représentent des parties des zones actives des transistors 120 des cellules mémoire du dispositif 100, et les traits pointillés désignés par la référence 128 délimitent symboliquement les surfaces occupées par les deux cellules mémoire visibles sur cette figure.

Des exemples de signaux de programmation de cellules mémoire du dispositif 100 sont donnés ci-dessous en lien avec la figure 6 représentant schématiquement une partie de la matrice de cellules mémoire dont certaines sont destinées à être programmées par ces signaux.

Le premier tableau ci-dessous donne des exemples de tensions appliquées sur les premières lignes 102 et les deuxièmes lignes 114 pour programmer à l'état haut (« set ») les deux points mémoire 105 de la cellule mémoire couplée aux premières lignes 102 sur lesquelles les signaux SL2 et SL3 sont appliqués, et couplée à la deuxième ligne 114 sur laquelle le signal BL2 est appliqué. La tension Vset correspond à la tension souhaitée aux bornes d'un point mémoire 105 destiné à être programmé à l'état haut.

**[Table 1]**

| | BL1=Vset/2 | BL2=0 | BL3=Vset/2 | BL4=0 |
|---|---|---|---|---|
| SL1=0 | -Vset/2 | 0 | -Vset/2 | 0 |
| SL2=Vset | Vset/2 | Vset | Vset/2 | 0 |
| SL3=Vset | Vset/2 | Vset | Vset/2 | 0 |
| SL4=0 | -Vset/2 | 0 | -Vset/2 | 0 |

Le deuxième tableau ci-dessous donne des exemples de tensions appliquées sur les premières lignes 102 et les deuxièmes lignes 114 pour programmer à l'état bas (« reset ») ces mêmes deux points mémoire 105 de la cellule mémoire couplée aux premières lignes 102 sur lesquelles les signaux SL2 et SL3 sont appliqués, et couplée à la deuxième ligne 114 sur laquelle le signal BL2 est appliqué. La tension Vreset correspond à la tension souhaitée aux bornes d'un point mémoire 105 destiné à être programmé à l'état bas. Lors de cette programmation, les signaux WL2 et WL3, appliqués sur les troisièmes lignes 124 formant les grilles des transistors 120 qui sont couplés aux premières lignes sur lesquelles les signaux SL2 et SL3 sont appliqués, sont tels que ces transistors 120 sont à l'état passant.

**[Table 2]**

| | BL1=0 | BL2=Vreset | BL3=0 | BL4=0 |
|---|---|---|---|---|
| SL1=Vreset/2 | Vreset/2 | -Vreset/2 | -Vreset/2 | 0 |
| SL2=0 | 0 | Vreset | 0 | 0 |
| SL3=0 | 0 | Vreset | 0 | 0 |
| SL4=Vreset/2 | Vreset/2 | -Vreset/2 | -Vreset/2 | 0 |

Dans ce mode de réalisation particulier, les cellules mémoire du dispositif 100 peuvent être vues comme étant de type 1T2R. Les cellules mémoire du dispositif 100 peuvent être programmées indépendamment les unes des autres moyennant un protocole de lecture / écriture adapté de type crossbar.

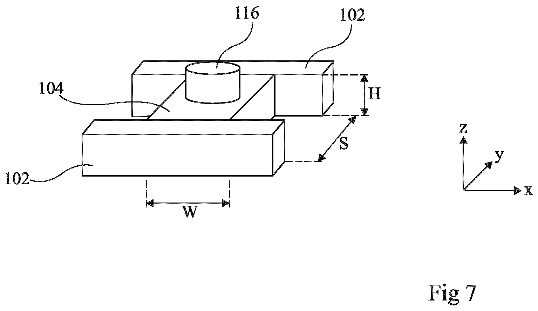

Quel que soit l'exemple de réalisation du dispositif 100, du fait que chaque point mémoire 105 est formé par l'empilement des électrodes 106, 108, de la couche 110 et de la portion 112 agencé « horizontalement », c'est-à-dire en s'étendant entre l'une des premières lignes 102 et l'une des portions 104 selon une direction appartenant au plan dans lequel se trouvent les premières lignes 102 et les portions 104, c'est-à-dire parallèlement au plan de la matrice de cellules mémoire du dispositif 100, la valeur de la tension permettant de programmer les cellules mémoire, la variabilité des paramètres électriques et le rendement des cellules mémoire dépendent des dimensions H et W des points mémoire 105 dans le plan parallèle au plan (X, Z), visibles sur la figure 7, et non des dimensions S et W dans le plan (X,Y). La réduction des dimensions des cellules mémoire dans le plan de la matrice de cellules mémoire du dispositif 100 peut donc être compensée par une augmentation de la dimension perpendiculaire à ce plan (c'est-à-dire la dimension selon l'axe vertical Z) et ainsi éviter qu'apparaissent les problèmes précédemment mentionnés et rencontrés avec des points mémoire à architecture verticale.

Dans tous les exemples de réalisation du dispositif 100, la disposition des points mémoires aux interfaces entre les portions métalliques 104 et les premières lignes 102 permet de doubler la surface du point mémoire pour une taille de bitcell (cellule de bit) donnée et donc de doubler la densité de mémoire pour une surface de wafer donnée.

Par exemple, pour une surface de cellule mémoire de l'ordre de 0,05 µm², la surface active totale des points mémoire 105 de la cellule peut être de l'ordre de 0,015 µm², cette surface pouvant être encore augmentée en augmentant l'épaisseur H des premières lignes 102 et des portions métalliques 104.

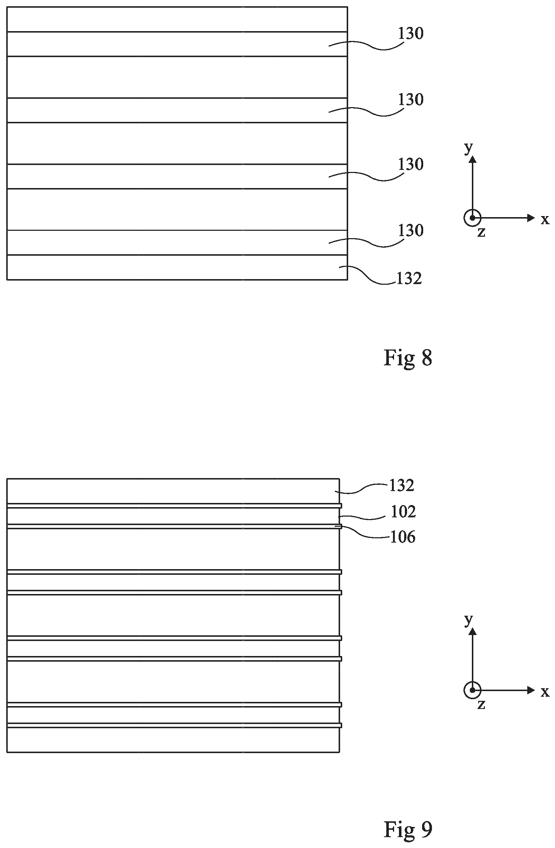

Un exemple de procédé de réalisation d'un dispositif mémoire 100 est décrit ci-dessous, les figures 8 à 13 représentant une partie de ces étapes.

Dans cet exemple, le procédé comporte tout d'abord la réalisation, à partir de la couche de semi-conducteur 118 du substrat, des différents composants semi-conducteurs du dispositif 100, et notamment les transistors 120 de sélection des cellules mémoire du dispositif 100.

Les différents niveaux de métallisation destinés à former le BEOL du circuit sont ensuite réalisés. Un des niveaux de métallisation est notamment réalisé tel qu'il comporte les troisièmes lignes 124 formant les grilles des transistors 120. Ces troisièmes lignes 124 sont par exemple réalisées par la mise en œuvre d'étapes de gravure et de dépôt à travers une couche diélectrique préalablement déposée.

Le procédé est ensuite poursuivi de manière à réaliser les premières lignes 102 parallèles les unes aux autres, les portions métalliques 104 parallèles les unes des autres et couplant électriquement chacune deux premières lignes 102 voisines, et en réalisant également, à chaque interface d'une des portions métalliques 104 et d'une des premières lignes 102, un point mémoire 105 de type OxRAM comprenant les première et deuxièmes électrodes 106, 108, la couche mémoire 110 et la portion de matériau getter 112.

Pour cela, selon un exemple, des premières tranchées 130 définissant des emplacements pour les premières lignes 102 sont gravées dans une première couche diélectrique 132 comprenant par exemple du SiO₂ (voir figure 8). L'épaisseur (dimension parallèle à l'axe Z) de la première couche diélectrique 132 est par exemple égale à la hauteur H souhaitée pour les premières lignes 102.

Un procédé dit « damascène » est par exemple mis en œuvre pour former les premières lignes 102 ainsi que les premières électrodes 106. Pour cela, les premières tranchées 130 sont remplies par au moins un premier matériau métallique destiné à former les premières électrodes 106 et au moins un deuxième matériau métallique destiné à former les premières lignes 102 (voir figure 9). Selon un exemple, ce remplissage des premières tranchées 130 peut comporter un dépôt d'une couche de TiN contre les parois des premières tranchées 130 et destinée à former les premières électrodes 106, puis un remplissage du volume restant des premières tranchées 130 par du tungstène destiné à former les premières lignes 102. Le ou les portions de matériaux métalliques déposées en dehors des premières tranchées 130 peuvent ensuite être supprimées en mettant en œuvre une planarisation mécano-chimique (CMP) avec arrêt sur la première couche diélectrique 132. En variante, les premières électrodes 106 peuvent être formées par un dépôt d'une couche de nitrure de tungstène, de cobalt ou de cuivre.

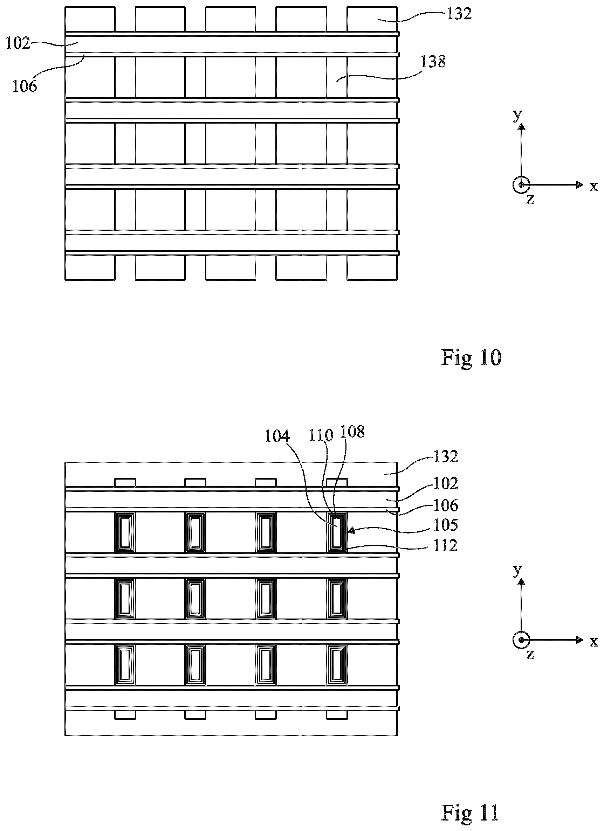

Des premiers trous 138 définissant des emplacements pour les portions métalliques 104 et les points mémoire 105 sont ensuite gravés dans la première couche diélectrique 132 (figure 10).

Les matériaux destinés à former les couches mémoire 110, les portions de matériau getter 112, les deuxièmes électrodes 108 et les portions métalliques 104 sont ensuite déposés successivement dans les premiers trous 138 (figure 11). Les parties de ces matériaux déposées en dehors des premiers trous 138 peuvent être supprimées en mettant en œuvre une CMP avec arrêt sur la première couche diélectrique 132.

En variante de l'exemple ci-dessus, il est possible que les premières électrodes 106 ne soient pas réalisées par le dépôt d'une première couche métallique dans les premières tranchées 130, mais par le dépôt d'une première couche métallique dans les premiers trous 138 mis en œuvre avant le dépôt du matériau destiné à former les couches mémoire 110.

Le procédé est ensuite poursuivi de manière à réaliser, dans un niveau de métallisation localisé au-dessus de celui comportant les premières lignes 102, les deuxièmes lignes 114 et les vias 116.

Pour cela, au moins une deuxième couche diélectrique 140 est déposée sur la première couche diélectrique 132, les premières lignes 102, les portions métalliques 104 et les points mémoire 105.

Un procédé dit « double damascène » peut être mis en œuvre pour former les deuxièmes lignes 114 et les vias 116.

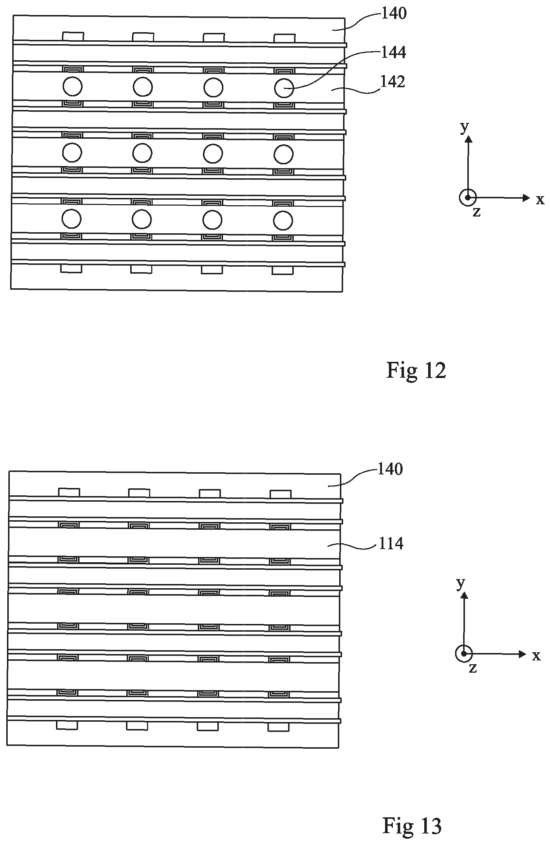

Dans ce cas, des deuxièmes tranchées 142 parallèles les unes aux autres et définissant des emplacements pour les deuxièmes lignes 114 sont ensuite gravées à travers une première partie de l'épaisseur de la deuxième couche diélectrique 140. Des deuxièmes trous 144 définissant des emplacements pour les vias 116 sont ensuite gravés à travers une deuxième partie de l'épaisseur de la deuxième couche diélectrique 140 et sous les deuxièmes tranchées 142, à l'aplomb des portions métalliques 104 (figure 12).

Au moins un autre matériau métallique est ensuite déposé dans les deuxièmes trous 144 et dans les deuxièmes tranchées 142, formant les deuxièmes lignes 114 et les premiers vias 116 couplant électriquement les deuxièmes lignes 114 aux portions métalliques 114 (figure 13).

En variante de l'exemple ci-dessus, il est possible de réaliser tout d'abord les vias 116 par des étapes de gravure et dépôt à travers une deuxième couche diélectrique déposée sur la premières couche diélectrique 132, les premières lignes 102, les portions métalliques 104 et les points mémoire 105. Les deuxièmes lignes 114 peuvent ensuite être réalisées par des étapes de gravure et dépôt à travers une troisième couche diélectrique déposée sur la deuxième couche diélectrique et les vias 116.

En variante, la réalisation des vias 116 peut être évitée en connectant directement deux à deux les deuxièmes lignes 114 et les portions métalliques 104 à chaque intersection.

En variante des exemples de réalisation précédemment décrits dans lesquels les transistors 120 sont couplés électriquement aux premières lignes 102 par les deuxièmes vias 122, il est possible que l'une des électrodes de source ou de drain de chacun des transistors 120 soit couplée électriquement à l'une des portions métalliques 104 par l'un des deuxièmes vias 122. Dans ce cas, chaque deuxième via 122 peut s'étendre entre la couche de semi-conducteur 118 et l'une des portions métalliques 104. De plus, dans cette variante, les deuxièmes lignes 114 formant les lignes de bit peuvent être disposées perpendiculairement aux premières lignes 102 et être couplées électriquement aux premières lignes 102 éventuellement par les premiers vias 116, et les lignes de source du dispositif 100 peuvent être couplées aux portions métalliques 104.

Divers exemples de réalisation et variantes ont été décrits. La personne du métier comprendra que certaines caractéristiques de ces divers exemples de réalisation et variantes pourraient être combinées, et d'autres variantes apparaîtront à la personne du métier.

Enfin, la mise en œuvre pratique des exemples de réalisation et variantes décrits est à la portée de la personne du métier à partir des indications fonctionnelles données ci-dessus. Par exemple, la nature précise des étapes de dépôt et de gravures mises en œuvre peut être choisie en fonction notamment du ou des matériaux à déposer ou à graver, ainsi que des épaisseurs de matériau à déposer ou à graver.

## Revendications

1. Dispositif mémoire (100) comprenant un substrat (SUB), le dispositif mémoire (100) comprenant, dans un premier niveau de métallisation :
- des premières lignes d'interconnexion électrique (102) parallèles les unes aux autres,
- des portions métalliques (104) parallèles les unes aux autres et couplant électriquement chacune deux premières lignes d'interconnexion électrique (102) voisines,
dans lequel un point mémoire (105) de type OxRAM ou CBRAM est disposé à chaque interface entre une des portions métalliques (104) et une des premières lignes d'interconnexion électrique (102), et chaque point mémoire (105) comprend une première électrode (106) disposée contre ladite une des premières lignes d'interconnexion électrique (102), une deuxième électrode (108) disposée contre ladite une des portions métalliques (104), et une couche mémoire (110) disposée entre les première et deuxième électrodes (106, 108),
**caractérisé en ce que** les premières lignes d'interconnexion électrique (102), les portions métalliques (104) et les points mémoires (105) sont disposés dans un même plan longitudinal parallèle au substrat (SUB) du dispositif mémoire (100).

2. Dispositif mémoire (100) selon la revendication 1, dans lequel chaque point mémoire (105) comporte en outre une portion de matériau getter (112) disposée entre la couche mémoire (110) et l'une des première et deuxième électrodes (106, 108).

3. Dispositif mémoire (100) selon l'une des revendications précédentes, comprenant en outre, dans un deuxième niveau de métallisation parallèle au premier niveau de métallisation, des deuxièmes lignes d'interconnexion électrique (114) parallèles les unes aux autres et couplées électriquement aux portions métalliques (104) ou aux premières lignes d'interconnexion électrique (102).

4. Dispositif mémoire (100) selon la revendication 3, comprenant en outre des premiers vias électriquement conducteurs (116) couplant électriquement les deuxièmes lignes d'interconnexion électrique (114) aux portions métalliques (104) ou aux premières lignes d'interconnexion électrique (102).

5. Dispositif mémoire (100) selon l'une des revendications 3 ou 4, dans lequel, lorsque les deuxièmes lignes d'interconnexion électrique (114) sont couplées électriquement aux portions métalliques (102), les premières lignes d'interconnexion électrique (102) sont des lignes de source du dispositif mémoire (100) et les deuxièmes lignes d'interconnexion électrique (114) sont des lignes de bits du dispositif mémoire (100).

6. Dispositif mémoire (100) selon l'une des revendications 3 à 5, dans lequel le premier niveau de métallisation est disposé entre le deuxième niveau de métallisation et le substrat (SUB) du dispositif mémoire (100).

7. Dispositif mémoire (100) selon la revendication 6, dans lequel le substrat (SUB) comporte une couche de semi-conducteur (118) dans laquelle sont formés des transistors (120) dont l'une des électrodes de source ou de drain de chacun des transistors (120) est couplée électriquement à l'une des premières lignes d'interconnexion électrique (102) ou à l'une des portions métalliques (104) par un deuxième via électriquement conducteur (122) s'étendant entre la couche de semi-conducteur (118) et ladite une des premières lignes d'interconnexion électrique (102) ou entre la couche de semi-conducteur (118) et ladite une des portions métalliques (104).

8. Dispositif mémoire (100) selon la revendication 7, comprenant, dans un troisième niveau de métallisation parallèle aux premier et deuxième niveaux de métallisation et tel que le premier niveau de métallisation soit disposé entre les deuxième et troisième niveaux de métallisation, des troisièmes lignes d'interconnexion électrique (124) parallèles les unes aux autres et perpendiculaires aux premières lignes d'interconnexion électrique (102), et dans lequel les troisièmes lignes d'interconnexion électrique (124) sont couplées électriquement aux grilles des transistors (120).

9. Dispositif mémoire (100) selon l'une des revendications 3 à 8, dans lequel chacune des deux premières lignes d'interconnexion électrique (102) voisines est couplée électriquement à des points mémoire (105) qui sont couplés électriquement à des deuxièmes lignes d'interconnexion électrique (114) différentes.

10. Dispositif mémoire (100) selon l'une des revendications précédentes, dans lequel les premières lignes d'interconnexion électrique (102) s'étendent dans un plan perpendiculaire à des faces de plus grandes dimensions de la couche mémoire (110) et des première et deuxième électrodes (106, 108).

11. Procédé de réalisation d'un dispositif mémoire (100) comprenant un substrat (SUB), le procédé comprenant au moins :
- réalisation, dans un premier niveau de métallisation, de premières lignes d'interconnexion électrique (102) parallèles les unes aux autres, et de portions métalliques (104) parallèles les unes aux autres et couplant électriquement chacune deux premières lignes d'interconnexion électrique (102) voisines,
- réalisation, à chaque interface entre une des portions métalliques (104) et une des premières lignes d'interconnexion électrique (102), d'un point mémoire (105) de type OxRAM ou CBRAM comprenant une première électrode (106) disposée contre ladite une des premières lignes d'interconnexion électrique (102), une deuxième électrode (108) disposée contre ladite une des portions métalliques (104), et une couche mémoire (110) disposée entre les première et deuxième électrodes (106, 108),
et **caractérisé en ce que** les premières lignes d'interconnexion électrique (102), les portions métalliques (104) et les points mémoires (105) sont réalisés dans un même plan longitudinal parallèle au substrat (SUB) du dispositif mémoire (100).

12. Procédé selon la revendication 11, dans lequel les premières lignes d'interconnexion électrique (102), les portions métalliques (104) et les points mémoire (105) sont réalisés en mettant en œuvre les étapes suivantes :
- gravure, dans une première couche diélectrique (132), de premières tranchées (130) définissant des emplacements pour les premières lignes d'interconnexion électrique (102),
- dépôt d'au moins un premier matériau métallique dans les premières tranchées, formant les premières électrodes (106) des points mémoire (105), et d'au moins un deuxième matériau métallique formant les premières lignes d'interconnexion électrique (102),
- gravure, dans la première couche diélectrique (132), de premiers trous (138) définissant des emplacements pour les portions métalliques (104) et les points mémoire (105),
- dépôts successifs de plusieurs matériaux dans les premiers trous (138), formant les points mémoire (105) et les portions métalliques (104).

13. Procédé selon l'une des revendications 11 ou 12, comportant en outre, après la réalisation des premières lignes d'interconnexion électrique (102), des portions métalliques (104) et des points mémoire (105) :
- dépôt d'au moins une deuxième couche diélectrique (140) sur les premières lignes d'interconnexion électrique (102), les portions métalliques (104) et les points mémoire (105),
- gravure, à travers une première partie de l'épaisseur de la deuxième couche diélectrique (140), de deuxièmes tranchées (142) parallèles les unes aux autres et définissant des emplacements pour des deuxièmes lignes d'interconnexion électrique (114),
- gravure, à travers une deuxième partie de l'épaisseur de la deuxième couche diélectrique (140), sous les deuxièmes tranchées (142) et à l'aplomb des portions métalliques (104) ou des premières lignes d'interconnexion électrique (102), de deuxièmes trous (144) définissant des emplacements pour des premiers vias électriquement conducteur (116),
- dépôt d'au moins un autre matériau métallique dans les deuxièmes trous (144) et dans les deuxièmes tranchées (142), formant les deuxièmes lignes d'interconnexion électrique (114) et les premiers vias électriquement conducteur (116) couplant électriquement l'une des deuxièmes lignes d'interconnexion électrique (114) aux portions métalliques (104) ou aux premières lignes d'interconnexion électrique (102).

14. Procédé selon l'une des revendications 11 à 13, comportant en outre, préalablement à la réalisation des premières lignes d'interconnexion électrique (102), des portions métalliques (104) et des points mémoire (105), la réalisation, à partir d'une couche de semi-conducteur (118) du substrat (SUB), de transistors (120) dont l'une des électrodes de source ou de drain de chacun des transistors (120) est couplée électriquement à l'une des premières lignes d'interconnexion électrique (102) ou à l'une des portions métalliques (104) par un deuxième via électriquement conducteur (122) s'étendant entre la couche de semi-conducteur (118) et ladite une des premières lignes d'interconnexion électrique (102) ou entre la couche de semi-conducteur (118) et ladite une des portions métalliques (104).

15. Procédé selon la revendication 14, dans lequel la réalisation des transistors (120) inclut la réalisation de grilles couplées électriquement à des troisièmes lignes d'interconnexion électrique (124) parallèles les unes aux autres et perpendiculaires aux premières lignes d'interconnexion électrique (102).

## Patentansprüche

1. Speichervorrichtung (100) mit einem Substrat (SUB), wobei die Speichervorrichtung (100) in einer ersten Metallisierungsebene folgendes aufweist:
- erste elektrische Verbindungsleitungen (102), die parallel zueinander verlaufen,
- Metallabschnitte (104), die parallel zueinander verlaufen und jeweils zwei benachbarte erste elektrische Verbindungsleitungen (102) elektrisch koppeln,
wobei ein Speicherelement (105) vom Typ OxRAM oder CBRAM an jeder Schnittstelle zwischen einem der Metallabschnitte (104) und einer der ersten elektrischen Verbindungsleitungen (102) angeordnet ist und jedes Speicherelement (105) eine erste Elektrode (106) aufweist, die an der einen der ersten elektrischen Verbindungsleitungen (102) angeordnet ist, eine zweite Elektrode (108), die an dem einen der Metallabschnitte (104) angeordnet ist, und eine Speicherschicht (110), die zwischen der ersten und der zweiten Elektrode (106, 108) angeordnet ist,
**dadurch gekennzeichnet, dass** die ersten elektrischen Verbindungsleitungen (102), die Metallabschnitte (104) und die Speicherelemente (105) in einer gleichen Längsebene parallel zum Substrat (SUB) der Speichervorrichtung (100) angeordnet sind.

2. Speichervorrichtung (100) gemäß Anspruch 1, wobei jedes Speicherelement (105) ferner einen Abschnitt aus Getter-Material (112) aufweist, der zwischen der Speicherschicht (110) und einer der ersten und zweiten Elektroden (106, 108) angeordnet ist.

3. Speichervorrichtung (100) gemäß einem der vorhergehenden Ansprüche, die ferner in einer zweiten Metallisierungsebene parallel zur ersten Metallisierungsebene zweite elektrische Verbindungsleitungen (114) aufweist, die parallel zueinander verlaufen und elektrisch mit den Metallabschnitten (104) oder mit den ersten elektrischen Verbindungsleitungen (102) gekoppelt sind.

4. Speichervorrichtung (100) gemäß Anspruch 3, die ferner erste elektrisch leitende Durchkontaktierungen (116) aufweist, die die zweiten elektrischen Verbindungsleitungen (114) elektrisch mit den Metallabschnitten (104) oder mit den ersten elektrischen Verbindungsleitungen (102) koppeln.

5. Speichervorrichtung (100) gemäß einem der Ansprüche 3 oder 4, wobei, wenn die zweiten elektrischen Verbindungsleitungen (114) elektrisch mit den Metallabschnitten (102) verbunden sind, die ersten elektrischen Verbindungsleitungen (102) Source-Leitungen der Speichervorrichtung (100) sind und die zweiten elektrischen Verbindungsleitungen (114) Bitleitungen der Speichervorrichtung (100) sind.

6. Speichervorrichtung (100) gemäß einem der Ansprüche 3 bis 5, wobei die erste Metallisierungsebene zwischen der zweiten Metallisierungsebene und dem Substrat (SUB) der Speichervorrichtung (100) angeordnet ist.

7. Speichervorrichtung (100) gemäß Anspruch 6, wobei das Substrat (SUB) eine Halbleiterschicht (118) aufweist, in der Transistoren (120) ausgebildet sind, wobei eine der Source- oder Drain-Elektroden jedes der Transistoren (120) elektrisch mit einer der ersten elektrischen Verbindungsleitungen (102) oder mit einem der Metallabschnitte (104) durch eine zweite elektrisch leitende Durchkontaktierung (122) gekoppelt ist, die sich zwischen der Halbleiterschicht (118) und der einen der ersten elektrischen Verbindungsleitungen (102) oder zwischen der Halbleiterschicht (118) und dem einen der Metallabschnitte (104) erstreckt.

8. Speichervorrichtung (100) gemäß Anspruch 7, aufweisend in einer dritten Metallisierungsebene parallel zur ersten und zweiten Metallisierungsebene und derart angeordnet, dass die erste Metallisierungsebene zwischen der zweiten und dritten Metallisierungsebene angeordnet ist, dritte elektrische Verbindungsleitungen (124) parallel zueinander und senkrecht zu den ersten elektrischen Verbindungsleitungen (102), wobei die dritten elektrischen Verbindungsleitungen (124) elektrisch mit den Gates der Transistoren (120) gekoppelt sind.

9. Speichervorrichtung (100) gemäß einem der Ansprüche 3 bis 8, wobei jede der zwei benachbarten ersten elektrischen Verbindungsleitungen (102) elektrisch mit Speicherelementen (105) gekoppelt ist, die elektrisch mit verschiedenen zweiten elektrischen Verbindungsleitungen (114) gekoppelt sind.

10. Speichervorrichtung (100) gemäß einem der vorhergehenden Ansprüche, wobei sich die ersten elektrischen Verbindungsleitungen (102) in einer Ebene senkrecht zu Flächen mit größeren Abmessungen der Speicherschicht (110) und den ersten und zweiten Elektroden (106, 108) erstrecken.

11. Verfahren zur Herstellung einer Speichervorrichtung (100) mit einem Substrat (SUB), wobei das Verfahren mindestens folgendes aufweist:
- Ausbilden, in einer ersten Metallisierungsebene, von ersten elektrischen Verbindungsleitungen (102), die parallel zueinander verlaufen, und von Metallabschnitten (104), die parallel zueinander verlaufen und jeweils zwei benachbarte erste elektrische Verbindungsleitungen (102) elektrisch koppeln,
- Ausbilden an jeder Schnittstelle zwischen einem der Metallabschnitte (104) und einer der ersten elektrischen Verbindungsleitungen (102) eines Speicherelements (105) vom Typ OxRAM oder CBRAM, mit einer ersten Elektrode (106), die an der einen der ersten elektrischen Verbindungsleitungen (102) angeordnet ist, einer zweiten Elektrode (108), die an dem einen der Metallabschnitte (104) angeordnet ist, und einer Speicherschicht (110), die zwischen der ersten und der zweiten Elektrode (106, 108) angeordnet ist,
und **dadurch gekennzeichnet, dass** die ersten elektrischen Verbindungsleitungen (102), die Metallabschnitte (104) und die Speicherelemente (105) in derselben Längsebene parallel zum Substrat (SUB) der Speichervorrichtung (100) ausgebildet werden.

12. Verfahren gemäß Anspruch 11, wobei die ersten elektrischen Verbindungsleitungen (102), die Metallabschnitte (104) und die Speicherelemente (105) durch Durchführung der folgenden Schritte ausgebildet werden:
- Ätzen erster Gräben (130), die Positionen für die ersten elektrischen Verbindungsleitungen (102) definieren, in eine erste dielektrische Schicht (132),
- Abscheiden, in den ersten Gräben, mindestens eines ersten metallischen Materials, das die ersten Elektroden (106) der Speicherelemente (105) bildet und mindestens eines zweiten metallischen Materials, das die ersten elektrischen Verbindungsleitungen (102) bildet,
- Ätzen erster Löcher (138) in die erste dielektrische Schicht (132), die die Positionen für die Metallteile (104) und die Speicherelemente (105) definieren,
- aufeinanderfolgendes Abscheiden einer Vielzahl von Materialien in die ersten Löcher (138), die die Speicherelemente (105) und die Metallabschnitte (104) bilden.

13. Verfahren gemäß einem der Ansprüche 11 oder 12, das nach dem Ausbilden der ersten elektrischen Verbindungsleitungen (102), der Metallabschnitte (104) und der Speicherelemente (105) ferner folgendes aufweist:
- Abscheiden mindestens einer zweiten dielektrischen Schicht (140) auf den ersten elektrischen Verbindungsleitungen (102), den Metallabschnitten (104) und den Speicherelementen (105),
- Ätzen von zweiten Gräben (142), die parallel zueinander verlaufen und Positionen für zweite elektrische Verbindungsleitungen (114) definieren, durch einen ersten Teil der Dicke der zweiten dielektrischen Schicht (140),
- Ätzen, durch einen zweiten Teil der Dicke der zweiten dielektrischen Schicht (140), unter den zweiten Gräben (142) und vertikal in einer Linie mit den Metallabschnitten (104) oder den ersten elektrischen Verbindungsleitungen (102), von zweiten Löchern (144), die Positionen für erste elektrisch leitende Durchkontaktierungen (116) definieren,
- Abscheiden mindestens eines weiteren metallischen Materials in die zweiten Löcher (144) und in die zweiten Gräben (142), das die zweiten elektrischen Verbindungsleitungen (114) und die ersten elektrisch leitenden Durchkontaktierungen (116) bildet, die eine der zweiten elektrischen Verbindungsleitungen (114) elektrisch mit den Metallabschnitten (104) oder mit den ersten elektrischen Verbindungsleitungen (102) koppelt.

14. Verfahren gemäß einem der Ansprüche 11 bis 13, das vor dem Ausbilden der ersten elektrischen Verbindungsleitungen (102) der Metallabschnitte (104) und der Speicherzellen (105) das Ausbilden von Transistoren (120) aus einer Halbleiterschicht (118) des Substrats (SUB) aufweist, wobei eine der Source- oder Drain-Elektroden jedes der Transistoren (120) elektrisch mit einer der ersten elektrischen Verbindungsleitungen (102) oder mit einem der Metallabschnitte (104) gekoppelt ist, und zwar durch eine zweite elektrisch leitende Durchkontaktierung (122), die sich zwischen der Halbleiterschicht (118) und der einen der ersten elektrischen Verbindungsleitungen (102) oder zwischen der Halbleiterschicht (118) und dem einen der Metallabschnitte (104) erstreckt.

15. Verfahren gemäß Anspruch 14, wobei das Ausbilden der Transistoren (120) das Ausbilden von Gates aufweist, die elektrisch mit dritten elektrischen Verbindungsleitungen (124) gekoppelt sind, die parallel zueinander und senkrecht zu den ersten elektrischen Verbindungsleitungen (102) verlaufen.

## Claims

1. Memory device (100) comprising a substrate (SUB), the memory device (100) comprising, in a first metallization level:
- first electrical interconnection lines (102) parallel to one another,
- metal portions (104) parallel to one another and each electrically coupling two neighboring first electrical interconnection lines (102),
wherein a memory element (105) of OxRAM or CBRAM type is arranged at each interface between one of the metal portions (104) and one of the first electrical interconnection lines (102), and each memory element (105) comprises a first electrode (106) arranged against said one of the first electrical interconnection lines (102), a second electrode (108) arranged against said one of the metal portions (104), and a memory layer (110) arranged between the first and second electrodes (106, 108) ,
**characterized in that** the first electrical interconnection lines (102), the metal portions (104) and the memory elements (105) are arranged in a same longitudinal plane parallel to the substrate (SUB) of the memory device (100).

2. Memory device (100) according to claim 1, wherein each memory element (105) further comprises a portion of getter material (112) arranged between the memory layer (110) and one of the first and second electrodes (106, 108) .

3. Memory device (100) according to any one of previous claims, further comprising, in a second metallization level parallel to the first metallization level, second electrical interconnection lines (114) parallel to one another and electrically coupled to the metal portions (104) or to the first electrical interconnection lines (102) .

4. Memory device (100) according to claim 3, further comprising first electrically-conductive vias (116) electrically coupling the second electrical interconnection lines (114) to the metal portions (104) or to the first electrical interconnection lines (102).

5. Memory device (100) according to any one of claims 3 or 4, wherein, when the second electrical interconnection lines (114) are electrically coupled to the metal portions (102), the first electrical interconnection lines (102) are source lines of the memory device (100) and the second electrical interconnection lines (114) are bit lines of the memory device (100).

6. Memory device (100) according to any one of claims 3 to 5, wherein the first metallization level is arranged between the second metallization level and the substrate (SUB) of the memory device (100).

7. Memory device (100) according to claim 6, wherein the substrate (SUB) comprises a semiconductor layer (118) in which are formed transistors (120), one of the source or drain electrodes of each of the transistors (120) being electrically coupled to one of the first electrical interconnection lines (102) or to one of the metal portions (104) by a second electrically-conductive via (122) extending between the semiconductor layer (118) and said one of the first electrical interconnection lines (102) or between the semiconductor layer (118) and said one of the metal portions (104).

8. Memory device (100) according to claim 7, comprising, in a third metallization level parallel to the first and second metallization levels and such that the first metallization level is arranged between the second and third metallization levels, third electrical interconnection lines (124) parallel to one another and perpendicular to the first electrical interconnection lines (102), and wherein the third electrical interconnection lines (124) are electrically coupled to the gates of the transistors (120).

9. Memory device (100) according to any one of claims 3 to 8, wherein each of the two neighboring first electrical interconnection lines (102) is electrically coupled to memory elements (105) which are electrically coupled to different second electrical interconnection lines (114).

10. Memory device (100) according to any one of previous claims, wherein the first electrical interconnection lines (102) extend in a plane perpendicular to faces of larger dimensions of the memory layer (110) and of the first and second electrodes (106, 108).

11. Method of manufacturing a memory device (100) comprising a substrate (SUB), the method comprising at least:
- forming, in a first metallization level, of first electrical interconnection lines (102) parallel to one another, and of metal portions (104) parallel to one another and each electrically coupling two neighboring first electrical interconnection lines (102),
- forming, at each interface between one of the metal portions (104) and one of the first electrical interconnection lines (102), of a memory element (105) of OxRAM or CBRAM type comprising a first electrode (106) arranged against said one of the first electrical interconnection lines (102), a second electrode (108) arranged against said one of the metal portions (104), and a memory layer (110) arranged between the first and second electrodes (106, 108),
and **characterized in that** the first electrical interconnection lines (102), the metal portions (104), and the memory elements (105) are formed in the same longitudinal plane parallel to the substrate (SUB) of the memory device (100).

12. Method according to claim 11, wherein the first electrical interconnection lines (102), the metal portions (104), and the memory elements (105) are formed by implementing the following steps:
- etching, into a first dielectric layer (132), of first trenches (130) defining locations for the first electrical interconnection lines (102),
- deposition of at least one first metallic material into the first trenches, forming the first electrodes (106) of the memory elements (105), and of at least one second metallic material forming the first electrical interconnection lines (102),
- etching, into the first dielectric layer (132), of first holes (138) defining locations for the metal portions (104) and the memory elements (105),
- successive depositions of a plurality of materials into the first holes (138), forming the memory elements (105) and the metal portions (104).

13. Method according to any one of claims 11 or 12, further comprising, after the forming of the first electrical interconnection lines (102), of the metal portions (104), and of the memory elements (105):
- deposition of at least one second dielectric layer (140) on the first electrical interconnection lines (102), the metal portions (104), and the memory elements (105),
- etching, through a first part of the thickness of the second dielectric layer (140), of second trenches (142) parallel to one another and defining locations for second electrical interconnection lines (114),
- etching, through a second part of the thickness of the second dielectric layer (140), under the second trenches (142) and vertically in line with the metal portions (104) or the first electrical interconnection lines (102), of second holes (144) defining locations for first electrically-conductive vias (116),
- deposition of at least another metallic material into the second holes (144) and into the second trenches (142), forming the second electrical interconnection lines (114) and the first electrically-conductive vias (116) electrically coupling one of the second electrical interconnection lines (114) to the metal portions (104) or to the first electrical interconnection lines (102).

14. Method according to any one of claims 11 to 13, further comprising, prior to the forming of the first electrical interconnection lines (102), of the metal portions (104), and of the memory cells (105), the forming, from a semiconductor layer (118) of the substrate (SUB), of transistors (120), one of the source or drain electrodes of each of the transistors (120) being electrically coupled to one of the first electrical interconnection lines (102) or to one of the metal portions (104) by a second electrically-conductive via (122) extending between the semiconductor layer (118) and said one of the first electrical interconnection lines (102) or between the semiconductor layer (118) and said one of the metal portions (104).

15. Method according to claim 14, wherein the forming of the transistors (120) includes the forming of gates electrically coupled to third electrical interconnection lines (124) parallel to one another and perpendicular to the first electrical interconnection lines (102).
